Europäisches Patentamt

European Patent Office

Office européen des brevets

(11) Veröffentlichungsnummer: **0 154 719**
**B1**

# EUROPÄISCHE PATENTSCHRIFT

(45) Veröffentlichungstag der Patentschrift:
23.11.88

(51) Int. Cl.⁴: **H 05 K 7/20,** H 01 H 9/52

(21) Anmeldenummer: 84116256.3

(22) Anmeldetag: 22.12.84

(54) Elektrisches Schaltgerät.

(30) Priorität: 13.03.84 DE 3409037

(43) Veröffentlichungstag der Anmeldung:
18.09.85 Patentblatt 85/38

(45) Bekanntmachung des Hinweises auf die Patenterteilung:
23.11.88 Patentblatt 88/47

(84) Benannte Vertragsstaaten:
DE FR GB

(56) Entgegenhaltungen:
DE-A-2 456 802
DE-A-2 625 456
DE-A-2 823 699
DE-U-7 906 405

(73) Patentinhaber: ROBERT BOSCH GMBH, Postfach
50, D-7000 Stuttgart 1 (DE)

(72) Erfinder: Bentz, Willy, Alte Grossachsenheimer
Strasse 3, D-7123 Sachsenheim (DE)
Erfinder: Gansert, Willi, Geschwister- Scholl-
Strasse 34, D-7014 Kornwestheim (DE)
Erfinder: Jakob, Gert, Weissenseeweg 10, D-7000
Stuttgart 50 (DE)
Erfinder: Stammler, Kurt, Herrmann- Essig- strasse
52, D-7141 Schwieberdingen (DE)
Erfinder: Walter, Christoph, Dipl.- Ing.(FH),
Sudetenstrasse 22, D-7143 Vaihingen/Enz 2 (DE)

Anmerkung: Innerhalb von neun Monaten nach der Bekanntmachung des Hinweises auf die Erteilung des europäischen Patents im
Europäischen Patentblatt kann jedermann beim Europäischen Patentamt gegen das erteilte europäische Patent Einspruch einlegen.
Der Einspruch ist schriftlich einzureichen und zu begründen. Er gilt erst als eingelegt, wenn die Einspruchsgebühr entrichtet worden
ist (Art. 99(1) Europäisches Patentübereinkommen).

## Beschreibung

### Stand der Technik

Die Erfindung geht von einem elektrischen Schaltgerät nach der Gattung des Hauptanspruchs aus. Das bekannte Schaltgerät hat einen Kühlwinkel, auf dem abzuleitende Verlustwärme abgebende elektrische Bauelemente durch ein kammartiges Fixierteil aus isolierendem Kunststoff in ihrer seitlichen Lage fixiert und durch ein Federelement an den Kühlwinkel gepreßt sind. Bei kurzzeitig stark erwärmten elektrischen Bauelementen wie beispielsweise Transistoren TO 220 oder SOT 93 mit Kunststoffgehäuse reicht in nachteiliger Weise oft die Wärmeableitung durch das Kühlteil nicht aus.

Aus der DE-A-2 625 456 ist ein Halbleitergerät bekannt mit einem Kühlteil, bei dem mindestens ein eine wärmeleitende Grundplatte aufweisendes Bauelement unter Zwischenlage einer Isolierfolie mit einem Federelement an das Kühlteil gepreßt ist.

### Vorteile der Erfindung

Das erfindungsgemäße elektrische Schaltgerät mit den kennzeichnenden Merkmalen des Hauptanspruchs hat demgegenüber den Vorteil, daß auch bei abzuleitende Verlustwärme abgebenden elektrischen Bauelementen mit Kunststoffgehäuse die kurzzeitig auftretende hohe Verlustwärme schnell abgeleitet werden kann durch ein die Wärmekapazität des Kühlverbandes erhöhendes zusätzliches Kühlteil, das direkt an der Grundplatte des Bauelements anliegt. Das zusätzliche Kühlteil ist dazu in vorteilhafter Weise ebenfalls am Fixierteil gehalten und, vom Federelement an die Grundplatte gepreßt. Dabei ist als weiterer Vorteil anzusehen, daß das am ersten Kühlteil befestigte Federelement den ganzen Kühlverband am ersten Kühlteil zusammenhält.

Durch die in den Unteransprüchen aufgeführten Maßnahmen sind vorteilhafte Weiterbildungen des im Hauptanspruch angegebenen Schaltgeräts möglich. Besonders vorteilhaft ist es, das Fixierteil so auszubilden, daß das mindestens eine elektrische Bauelement sich nicht gegenüber dem mindestens einen zusätzlichen Kühlteil bewegen kann und somit das Beschädigen des Kunststoffgehäuses des beispielsweise als Transistor ausgebildeten Bauelements durch das zusätzliche Kühlteil verhindert werden kann; daß das Fixierteil mit mindestens einem elastischen Halteabschnitt versehen ist, über den das Federelement auf das zusätzliche Kühlteil drückt, und daß das Fixierteil Rastmittel hat, mit denen zum einen das Fixierteil am ersten Kühlteil und zum anderen das Federelement am Fixierteil lösbar befestigt werden können. Darüber hinaus ist es sehr vorteilhaft, das Federelement mit höherer Federkraft auf das Bauelement als auf das zusätzliche Kühlteil drücken zu lassen, um Schäden durch auf das Bauelement wirkende Kippmomente zu vermeiden sowie mit dem Federelement den ganzen Kühlverband zusammenzuhalten, in dem lediglich das Federelement am ersten Kühlteil befestigt ist. Dadurch wird eine wirtschaftliche Großmengenfertigung ermöglicht, Zeichnung.

Ein Ausführungsbeispiel der Erfindung ist in der Zeichnung dargestellt und in der nachfolgenden Beschreibung näher erläutert. Es zeigen

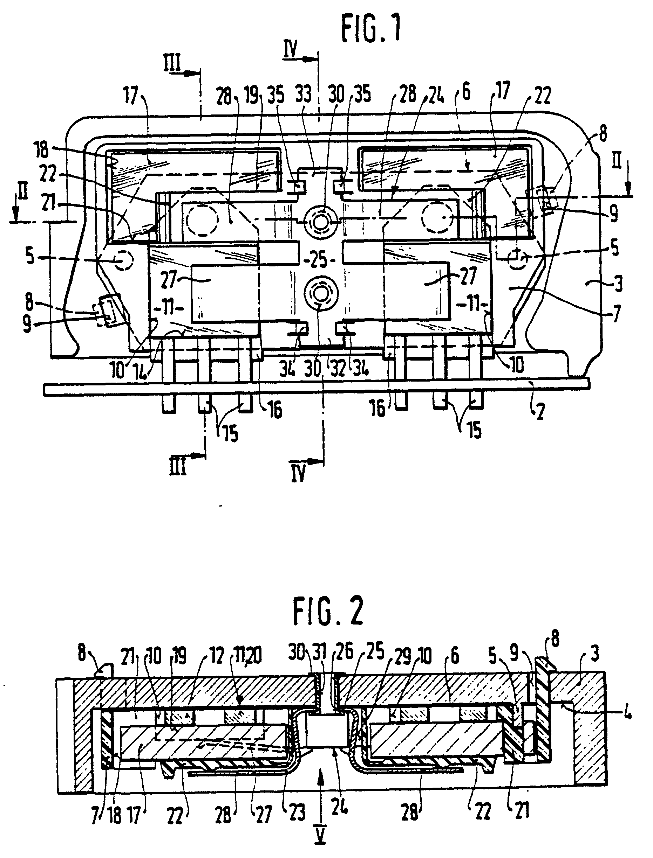

Figur 1 einen Teil eines elektrischen Schaltgeräts mit Kühlverband,
Figur 2 einen Schnitt entlang der Linie II - II,
Figur 3 einen Schnitt entlang der Linie III - III,
Figur 4 einen Schnitt entlang der Linie IV - IV jeweils in Figur 1 durch den Kühlverband und
Figur 5 eine Abwandlung bei V in Figur 2.

### Beschreibung des Ausführungsbeispieles

In einem an sich bekannten und nicht näher dargestellten elektrischen Schaltgerät ist ein Kühlrahmen 1 angeordnet. Am Kühlrahmen 1 ist in ebenfalls bekannter und nicht näher dargestellter Weise eine Leiterbahnen und elektrische und elektronische Bauelemente tragende Leiterplatte 2 befestigt. Der Kühlrahmen 1 weist einen als erstes Kühlteil 3 dienenden Bereich mit einer Kühlebene 4 auf. An der Kühlebene 4 stehen zwei Fixierzapfen 5 vor, an denen eine wärmeleitende Isolierfolie 6 und ein aus isolierendem Kunststoff gebildetes Fixierteil 7 in ihrer Lage am ersten Kühlteil 3 gehalten sind.

Das Fixierteil 7 ist mit zwei Rasthaken 8 versehen, welche durch zugeordnete Löcher 9 im ersten Kühlteil 3 ragen und an der Rückseite des ersten Kühlteils 3 verrastet sind. Durch die Rasthaken 8 ist das Fixierteil 7 am ersten Kühlteil 3 vormontiert. Das Fixierteil 7 ist mit zwei Durchbrüchen 10 versehen für zwei am ersten Kühlteil 3 in ihrer Lage gehaltene elektronische Bauelemente 11. Die elektronischen Bauelemente 11 sind beispielsweise Transistoren SOT 93, deren Verlustwärme abzuleiten ist. Dazu liegen die Bauelemente 11 mit ihrer Grundplatte 12 aus Metall auf der Isolierfolie 6 und somit am ersten Kühlteil 3. Am Fixierteil 7 sind die Durchbrüche 10 begrenzende Anschläge 13 und 14 angeformt, welche ein Bewegen der Bauelemente 11 im Fixierteil 7 auf der Isolierfolie 6 und somit auf der Kühlebene 4 verhindern. Im Bereich der Anschlußelektroden 15 der Bauelemente 11 ist das Fixierteil 7 mit die Unterkante des ersten Kühlteils 3 umgreifenden Isolierabschnitten 16 versehen. Die abgewinkelten Anschlußelektroden 15 der beiden Bauelemente 11 sind wie an sich bekannt mit zugehörigen Leiterbahnen der Leiterplatte 2 elektrisch leitend und mechanisch verbunden.

Um einen guten Wärmeübergang der abzuleitenden Verlustwärme der elektronischen Bauelemente 11 zu erreichen, sind die Bauelemente 11 durch Federkraft an das erste Kühlteil 3 unter Zwischenlage der Isolierfolie 6 gepreßt. Da bei dem elektrischen Schaltgerät die elektronischen Bauelemente 11 unter kurzfristig hohe Verlustwärme abgebenden Bedingungen arbeiten, reicht das die Verlustwärme aufnehmende und weiterleitende erste Kühlteil 3 oft nicht aus, so daß zu Schäden am Schaltgerät führende Wärmestaus entstehen können. Zum Vergrößern der Wärmeaufnahmekapazität liegt beispielsweise an jedem Bauelement 11 ein zweites Kühlteil 17 direkt an. Das zweite Kühlteil 17 ist eine nicht isolierte Metallplatte. Sie ist in eine Ausnehmung 18 des Fixierteils 7 eingesetzt und liegt an der dem ersten Kühlteil 3 abgewandten Seite 19 der Grundplatte 12 des Bauelements 11 an, soweit die Grundplatte 12 aus dem Kunststoffgehäuse 20 des beispielsweise als Transistor SOT 93 ausgebildeten Bauelements 11 ragt. Das zweite Kühlteil 17 ist durch einen Anschlag 21 des Fixierteils 7 in seiner Bewegung auf das Kunststoffgehäuse 20 des Bauelements 11 zu begrenzt, um es nicht zu beschädigen. Am Fixierteil 7 sind elastische Lappen 22 angeformt, und jeweils mittels eines Filmscharniers 23 am Fixierteil 7 schwenkbar befestigt. Die zweiten Kühlteile 17 sind mittels Federkraft an die Grundplatte 12 des zugeordneten Bauelements 11 gepreßt. Die Federkraft wirkt auf die an die der Grundplatte 12 abgewandte Seite der zweiten Kühlteile 17 geschwenkten Lappen 22 und hält zugleich die zweiten Kühlteile 17 im Fixierteil 7.

Sowohl die direkt auf die Bauelemente 11 als auch die auf die zweiten Kühlteile 17 wirkende Federkraft wird von einem Federelement 24 ausgeübt. Das Federelement 24 hat einen rechteckigen Befestigungsabschnitt 25 mit zwei Befestigungslöchern 26. An den Längsseiten des Befestigungsabschnittes 25 sind je zwei abgekröpfte Federarme 27, 28 angeformt. Die Federarme 27 liegen am Kunststoffgehäuse 20 des zugeordneten Bauelements 11 an, während die schmaler gestalteten, eine geringere Federkraft ausübenden Federarme 28 beim Einsetzen des Federelements 24 in das Fixierteil 7 dessen Lappen 22 um das jeweilige Filmscharnier 23 an das zugeordnete zweite Kühlteil schwenken und am Lappen 22 anliegen. Das Federelement 24 ist mit seinem rechteckigen Befestigungsabschnitt 25 in einen Durchbruch 29 des Fixierteils 7 eingesetzt. In die Löcher 26 sind zwei Hohlniete 30 eingesetzt, welche durch Bohrungen 31 des ersten Kühlteils 3 ragen und an der Rückseite des ersten Kühlteils 3 genietet sind.

An jeder Schmalseite des rechteckigen Befestigungsabschnittes 25 des Federelements 24 ist ein abgekröpfter Rastvorsprung 32 bzw. 33 angeformt. Die Rastvorsprünge 32 und 33 sind hinter Rastnasenpaare 34 bzw. 35 des Fixierteils 7 gedrückt. Dadurch hält das Federelement 24 bereits vor seinem Befestigen am ersten Kühlteil 3 den ganzen Kühlverband bestehend aus erstem Kühlteil 3, Isolierfolie 6, Fixierteil 7, elektronischen Bauelementen 11, zweiten Kühlteilen 17 und Federelement 24 zusammen.

Die kurzzeitig auftretende hohe Verlustwärme der elektronischen Bauelemente 11 wird nun nicht nur zum ersten Kühlteil 3 mit Wärmeübergang über die Isolierfolie 6 abgegeben und von dort abgeleitet. Gleichzeitig wird über die Grundplatte 12 der Bauelemente 11 Verlustwärme direkt an das zweite Kühlteil 17 abgegeben und dort gespeichert. Da die Verlustwärme nur über eine kurze Zeitspanne verhältnismäßig hohe Werte erreicht, wird die im zweiten Kühlteil 17 gespeicherte Verlustwärme danach über die Grundplatte 12 auf das erste Kühlteil 3 abgeleitet. Die Aufnahmekapazität für rasch vom elektronischen Bauelement 11 abzuleitende Verlustwärme ist somit in erfinderischer Weise mit geringen Mitteln wesentlich vergrößert, so daß kein unerwünschter Wärmestau am Bauelement 11 mehr entstehen kann.

Das zweite Kühlteil 17 kann auch so abgewandelt werden, daß es für zwei und mehr elektronische Bauelemente 11 als Speicher für abzuleitende Verlustwärme dient. Ebenso kann das Federelement 24 zum Anpressen nur eines oder mehrerer Bauelemente 11 ausgebildet sein.

Durch das Einrasten an den Rastnasenpaaren 34 und 35 am Fixierteil 7 ist das Federelement 24 auch gegen ungleiche Kippmomentbelastungen sicher gehalten. Die ungleichen Kippmomentbelastungen treten durch die unterschiedliche Federkraft der Federarme bzw. Federarmpaare 27 und 28 auf sowie bei unsymmetrisch zur Längsachse des Befestigungsabschnitts 25 angeformte Federarme 27, 28, wenn der Kühlverband für nur ein elektronisches Bauelement 11 zusammenzuhalten ist.

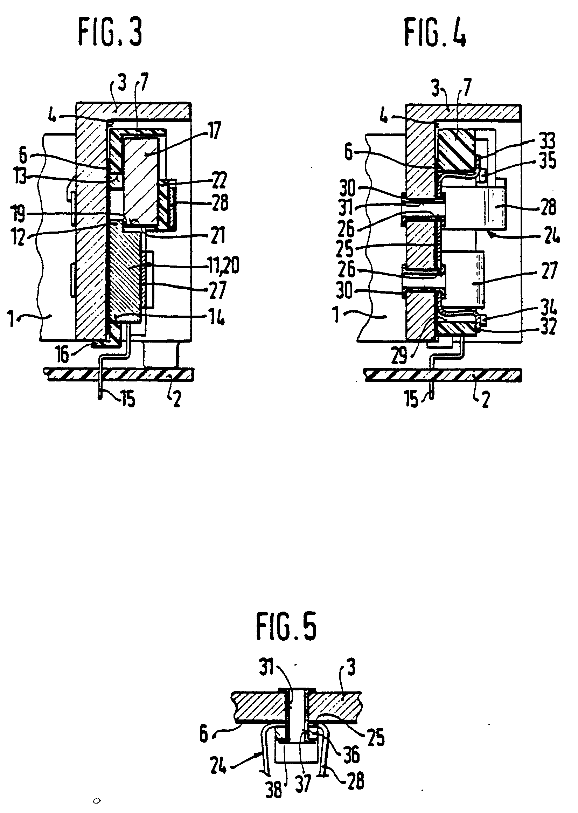

Um die Befestigung des den ganzen Kühlverband 3, 6, 7, 11, 17 zusammenhaltenden Federelements 24 für spezielle Anforderungen zusätzlich zu sichern, ist eine abgewandelte Befestigung in Figur 5 dargestellt. Auf dem Befestigungsabschnitt 25 des Federelements 24 ist eine Druckplatte 36 angeordnet. Sie ist mit zwei Befestungslöchern 37 versehen, die mit den Löchern 26 des Federelements 24 fluchten. Längere Hohlniete 38 sind durch die Druckplatte 36, das Federelement 24 und die Bohrungen 31 des ersten Kühlteils 3 gesteckt und an der Rückseite des ersten Kühlteils 3 genietet, oder die Hohlniete 38 sind vom Kühlteil 3 her durch die Löcher gesteckt und an der Druckplatte 36 genietet. Es ist auch möglich, das Federelement 24 lösbar am ersten Kühlteil 3, zum Beispiel mit Schrauben oder Rastmitteln, zu befestigen.

## Patentansprüche

1. Elektrisches Schaltgerät mit einem Kühlteil, an dem mindestens ein abzuleitende Verlustwärme abgebendes elektrisches Bauelement, welches eine wärmeleitende Grundplatte aufweist, unter Zwischenlage einer Isolierfolie mit einem Fixierteil aus Kunststoff in seiner Lage gehalten und mit einem Federelement an das Kühlteil gepreßt ist, dadurch gekennzeichnet, daß an der dem ersten Kühlteil (3) abgewandten Seite (19) des mindestens einen Bauelements (11) ein am Fixierteil (7) gehaltenes zweites Kühlteil (17) von dem lösbar am Fixierteil (7) angeordneten Federelement (24) an die wermeleitende Grundplatte (12) des Bauelements (11) gepreßt ist, und das Federelement (2)) den ganzen Kühlverband zusammenhaltend am ersten Kühlteil (3) befestigt ist.

2. Schaltgerät nach Anspruch 1, dadurch gekennzeichnet, daß das Fixierteil (7) am ersten Kühlteil (3) eingerastet ist.

3. Schaltgerät nach Anspruch 3 oder 2, dadurch gekennzeichnet, daß das Fixierteil (7) mit Bewegungen von Bauelement (11) und zweitem Kühlteil (17) gegeneinander parallel zu den Kühlebenen (4 und 19) verhindernden Anschlägen (13, 14; 21) versehen ist.

4. Schaltgerät nach einem der Ansprüche 1 bis 3, dadurch gekennzeichnet, daß das Fixierteil (7) mit mindestens einem elastischen Halteabschnitt (22) versehen ist, der vom Federelement (24; 28) schwenkbar an die Außenseite des zweiten Kühlteils (17) gedrückt ist.

5. Schaltgerät nach einem der Ansprüche 1 bis 4, dadurch gekennzeichnet, daß das Fixierteil (7) mit Rastmitteln (34, 35) versehen ist, an welchen das Federelement (24) einrastbar ist.

6. Schaltgerät nach einem der Ansprüche 1 bis 5, dadurch gekennzeichnet, daß das Federelement (24) mit zwei Federschenkeln (27, 28) fur jedes Bauelement (11) versehen ist, von deren der eine Schenkel (27) am Bauelement (11) und der andere Schenkel (28) am zweiten Kühlteil (17) anliegt.

7. Schaltgerät nach einem der Ansprüche 1 bis 6, dadurch gekennzeichnet, daß das Federelement (24) mit mindestens einem Rastabschnitt (32, 33) versehen ist, mit dem es am Fixierteil (7) lösbar befestigt ist.

8. Schaltgerät nach einem der Ansprüche 1 bis 7, dadurch gekennzeichnet, daß das Federelement (24) am Bauelement (11) mit höherer Federkraft als am zweiten Kühlteil (17) anpreßbar ist.

9. Schaltgerät nach einem der Ansprüche 1 bis 8, dadurch gekennzeichnet, daß jedem Bauelement (11) ein zweites Kühlteil (17) zugeordnet ist.

## Claims

1. Electrical switching device having a cooling part on which at least one electrical component giving off dissipated heat to be removed, which electrical component has a thermally conducting baseplate and is held in its position with interposition of an insulating foil with a fixing part of plastic and is pressed against the cooling part with a spring element, characterized in that on the side (19), facing away from the first cooling part (3), of at least one component (11), a second cooling part (17) held on the fixing part (7) is pressed by the spring element (24) detachably arranged on the fixing part (7) against the thermally conducting base-plate (12) of the component (11), and the spring element (24) is secured on the first cooling part (3) so as to hold together the entire cooling unit.

2. Switching device according to claim 1, characterized in that the fixing part (7) is engaged on the first cooling part (3).

3. Switching device according to claim 1 or 2, characterized in that the fixing part (7) is provided with stops (13, 14; 21) preventing movements of component (11) and second cooling part (17) towards each other parallel to the cooling planes (4 and 19).

4. Switching device according to one of claims 1 to 3, characterized in that the fixing part (7) is provided with at least one elastic securing section (22) which is pressed pivotably against the outer side of the cooling part (17) by the spring element (24; 28).

5. Switching device according to one of claims 1 to 4, characterized in that the fixing part (7) is provided with latch means (34; 35) on which the spring element (24) can be engaged.

6. Switching device according to one of claims 1 to 5, characterized in that the spring element (24) is provided with two spring legs (27, 28) for each component (11), one leg (27) of which lies against the component (11) and the other leg (28) lies against the second cooling part (17).

7. Switching device according to one of claims 1 to 6, characterized in that the spring element (24) is provided with at least one latch section (32, 33) with which it is detachably secured to the fixing part (7).

8. Switching device according to one of claims 1 to 7, characterized in that the spring element (24) can be pressed on the component (11) with greater spring force than on the second cooling part (17).

9. Switching device according to one of claims 1 to 8, characterized in that each component (11) is associated with a second cooling part (17).

## Revendications

1. Appareil de commutation électrique doté d'un élément refroidisseur, sur lequel au moins un composant électrique cédant de la chaleur perdue devant être évacuée, comportant une plaque-support conductrice de la chaleur, est maintenue dans sa position à l'aide d'un élément de fixation en matière plastique avec intercalation d'une feuille isolante et est appliqué par pression sur l'élément refroidisseur à l'aide d'un élément à ressorts, caractérisé en ce que, sur la face (19) d'au moins un composant (11), opposée au premier élément refroidisseur (3), un deuxième élément refroidisseur (17) maintenu sur l'élément de fixation (7) est appliqué par pression sur la plaque-support conductrice de la chaleur (12) du composant (11) à l'aide de l'élément à ressorts (24) monté de façon amovible sur l'élément de fixation (7) et que l'élément à ressorts (24) qui maintient l'ensemble du système de refroidissement est fixé au premier élément refroidisseur (3).

2. Appareil de commutation selon la revendication 1, caractérisé en ce que l'élément de fixation (7) est enclenché dans le premier élément refroidisseur (3).

3. Appareil de commutation selon la revendication 1 ou 2, caractérisé en ce que l'élément de fixation (7) est muni de butées (13, 14; 21) qui empêchent les mouvements du composant (11) et du deuxième élément refroidisseur (17) l'un par rapport à l'autre, parallèlement aux plans de refroidissement (4 et 19)

4. Appareil de commutation selon l'une des revendications 1 à 3, caractérisé en ce que l'élément de fixation (7) est muni d'au moins un sent d'appui élastique (22) qui est pressé en pivotant sur la face externe du deuxième élément refroidisseur (17) au moyen d'un élément à ressorts (24; 28).

5. Appareil de commutation selon l'une des revendications 1 à 4, caractérisé en ce que l'élément de fixation (7) est pourvu de moyens de verrouillage (34, 35) dans lesquels peut s'enclencher l'élément à ressorts (24).

6. Appareil de commutation selon l'une des revendications 1 à 5, caractérisé en ce que l'élément à ressorts (24) est muni de deux branches de ressort (27, 28) pour chaque composant (11), l'une des branches (27) portant sur le composant (11) et l'autre (28) portant sur le deuxième élément refroidisseur (17).

7. Appareil de commutation selon l'une des revendications 1 à 6, caractérisé en ce que l'élément à ressorts (24) est muni d'au moins un sent de verrouillage (32, 33) avec lequel il est fixé de manière amovible sur l'élément de fixation (7).

8. Appareil de commutation selon l'une des revendications 1 à 7, caractérisé en ce que l'élément à ressorts (24) peut être appliqué par pression sur le composant (11) avec une force élastique plus élevée que sur le deuxième élément refroidisseur (17).

9. Appareil de commutation selon l'une des revendications 1 à 8, caractérisé en ce qu'un deuxième élément refroidisseur (17) est associé à chaque composant (11).

# FIG. 1

# FIG. 2

# FIG. 3

# FIG. 4

# FIG. 5